# EUROPEAN PATENT SPECIFICATION

(11) **EP 4 389 956 B1**
(45) Date of publication and mention of the grant of the patent: **02.07.2025**
(21) Application number: 23214700.9
(22) Date of filing: 06.12.2023
(51) Int. Cl.: B21D 39/03, B21D 35/00, B21D 51/44, B21D 53/00, F16B 5/12, F16B 5/00, H05K 5/03, H05K 5/04, D06F 39/12

(54) **MANUFACTURING AND FIXING METHOD OF A COVER ON A METAL SHEET SECTION, A METAL SHEET SECTION COMPRISING A COVER MANUFACTURED AND FIXED ACCORDING TO SAID METHOD, A HOUSING COMPRISING SAID METAL SHEET SECTION AND AN ELECTRICAL HOUSEHOLD APPLIANCE COMPRISING SAID HOUSING**
VERFAHREN ZUM HERSTELLEN UND BEFESTIGEN EINES DECKELS AUF EINEM BLECHABSCHNITT, BLECHABSCHNITT MIT EINEM DECKEL HERGESTELLT UND BEFESTIGT NACH DIESEM VERFAHREN, GEHÄUSE MIT DIESEM BLECHABSCHNITT SOWIE ELEKTRISCHES HAUSGERÄT MIT DIESEM GEHÄUSE
PROCÉDÉ DE FABRICATION ET DE FIXATION D'UN COUVERCLE SUR UNE SECTION DE TÔLE, SECTION DE TÔLE COMPRENANT UN COUVERCLE FABRIQUÉ ET FIXÉ SUIVANT CE PROCÉDÉ, CAISSON COMPRENANT CETTE SECTION DE TÔLE ANSI QU' UN APPAREIL ELECTROMÉNAGER COMPRENANT CE CAISSON

(30) Priority: 23.12.2022 EP 22383276
(43) Date of publication of application: 26.06.2024
(73) Proprietor: BSH Hausgeräte GmbH, 81739 München (DE)
(72) Inventor: Lopez Palacios, Carlos, 50730 El Burgo de Ebro (Zaragoza) (ES)

(56) References cited:
- EP-A1- 0 278 998
- EP-A1- 4 071 292
- CN-B- 101 898 215

## Description

The invention relates to the field of the manufacturing and fixing of covers for openings in metal sheet sections comprising maintenance openings that need to be covered by a cover, said cover allowing access through this opening when activities requiring said access are to be carried out but avoiding said access when it is not necessary and maintaining a high mechanical resistance in said sheet section. The invention further relates to metal sheet sections comprising covers manufactured and fixed in accordance with the preceding manufacturing method. This further relates to housings comprising metal sheet sections that comprise at least a sheet section with a cover manufactured and fixed in accordance with said method as well as electrical household appliances comprising said housings.

Sheet sections are known in which a section of the same is cut out to create an opening, this cut-out section is subjected to stamping and stretching processes to make this sheet section bigger and use this enlarged or stretched sheet section as a cover of the opening previously left. These cut-out sheet sections are usually connected to the sheet section by means of additional connecting means such as screws preferably.

The housings of laundry care appliances are known requiring maintenance openings in its rear section mainly for the technical service workers to be allowed to access into said laundry care appliances to perform maintenance and repair tasks of the same. Said housings are normally manufactured by cutting out from the sheet what will be the access opening to, in a separate process, subject said cut-out sheet to stretching and enlarging processes of said sheet surface to make it slightly bigger than the opening from which they have been cut out and which can be subsequently mounted by additional fixing means (usually screws) and act as a cover of said opening.

Document EP-A-4071292 discloses a manufacturing and fixing method of a cover removable from an opening of a metal sheet section.

This type of solutions prioritises the facilitation of the work to the technical service employees but, in turn, weakens the structure of the sheet section as a whole since said covers are not of the same size as the opening they cover and this also makes the production process of said sets more complicated. The reason for this is that additional logistics during the manufacture of said sheet sections is required due to the fact that the sheet cut-outs need to be subjected to additional stretching or enlarging processes allowing the entire area of the opening to be closed and additional assembly tasks of said sheet cut-outs are to be carried out, which end up being covers of said openings.

In addition to that, maintenance and repair work is not always performed through these openings, so this weakening of the sheet section occurs and these additional resources for stretching and fixing the cover on the sheet section are spent without knowing if access through this opening will be or not necessary, being possible that no maintenance task is performed later.

Therefore, it is required to provide new production processes for manufacturing and fixing said covers on said sheet sections in such a manner that the mechanical resistance of the sheet section is weakened as little as possible, the size of the cover is virtually the same as that of the opening covered by it and that no additional operations to fix the cover to the sheet section are required.

The object of the present invention is to provide a manufacturing and fixing method of a cover to a metal sheet section while mechanically weakening said sheet section as little as possible as well as avoiding additional stretching and fixing processes of the cover to said housing section outside the production line of the own cover in the metal sheet section. Other advantageous features of the invention will be derived from the following description of this specification.

According to the invention, the manufacturing and fixing method of a cover removable from an opening of a metal sheet section comprises the following steps:
a. Defining a perimeter of the opening,
b. Cutting a first cutting line comprising a first end and a second end and cutting a second cutting line comprising a first end and a second end in such a manner that they cut the perimeter of the opening, a stamping surface being thereby defined between the cutting lines,
c. Repeating step b) at least three times along the perimeter of the opening, a total of at least four stamping surfaces being thereby defined,
d. Stamping the at least four stamping surfaces in a direction perpendicular to the plane defined by the stamping surface in such a manner that there are at least two stamping surfaces stamped in opposite senses of said direction perpendicular to the plane defined by the stamping surface in an alternating manner among the stamping surfaces,
e. Cutting the perimeter of the opening, at least four fixing lugs being thereby defined,
f. Flattening the fixing lugs located in the section, thereby bringing them back to the starting plane of the stamping surface,
g. Flattening the fixing lugs located in the cover, thereby bringing them back to the starting plane of the stamping surface in such a manner that at least four connecting surfaces are defined, or on the cover or on the section or on another fixing lug in such a manner that the cover remains fixed to the section without any additional fixing means

In this way, a cover can be manufactured and fixed in a metal sheet section in such a manner that the cover remains structurally fixed and fitted into the rest of the section, fits perfectly into the perimeter of the opening covered by it, can be made in a production line and, in addition, no additional fixing means are required. This is particularly interesting for openings of sheet sections provided for possible maintenance tasks or operations through said openings that will not be carried out regardless of the situation but only if certain failures or breakdowns occur.

A 'perimeter of an opening' is understood to be the perimeter of the intended window to guarantee access through the same for the performance of activities or tasks deemed to be necessary. The geometry of said cut can be regular or irregular, the required opening section being more important to perform the necessary servicing or repair tasks a posteriori. Examples of valid geometries for the perimeter are circles, squares, rectangles, rhombuses, ovals, regular polygons with n-sides, or geometries combining more than four sides, provided that at least two of them are parallel to each other and perpendicular to other two sides parallel to each other as well.

A 'stamping surface' is understood to be the surface comprised between the two cutting lines, an imaginary line connecting the first end of the first cutting line with the first end of the second cutting line and an imaginary line connecting the second end of the first cutting line with the second end of the second cutting line in such a manner that said imaginary lines do not intersect. It is a preferred embodiment when the stamping surface is contained between the cutting lines and the shortest straight line connecting the first ends of the cutting lines and the shortest straight line connecting the second ends of the cutting lines.

This step b) of the process is repeated at least three times more to guarantee the existence at least of four stamping surfaces, which will subsequently give rise to at least four connecting surfaces. This is the minimum number of connecting elements required by this cover to remain fixed structurally and in a resistant manner.

The stamping of said stamping surfaces occurs in a direction perpendicular to the plane containing the stamping surface. When the metal sheet is stamped along this surface, a lengthening of the sheet takes place and this lengthening will be utilised to obtain the connecting surface with the extra sheet length achieved by stretching said sheet by means of the stamping process.

The four stamping surfaces are preferably contained in parallel planes and, even more preferably, are contained in a sole plane. This greatly facilitates the manufacturing method of said cover in said sheet section. Furthermore, if the four stamping surfaces are contained in a sole plane, it is much easier to stamp in a direction perpendicular to the plane containing said surfaces. To guarantee the correct fixation of the cover on the sheet section, the at least four stamping surfaces need to be stamped in senses opposite to each other and in an alternating manner in such a way that two of the stamping surfaces remain in one sense and at least other two in the opposite stamping sense, and they are also arranged alternately to guarantee its correct fixation.

The final fixing lugs originate in the cutting operation of the perimeter. There are three options depending on how the perimeter has been defined with respect to the cutting lines. The first option is that the fixing lugs originate just in the section. The second option is that the fixing lugs originate only in the cover. The third and last one option is that the fixing lugs originate both in the section and in the cover.

In this third option, in which the fixing lugs originate both in the cover and in the sheet section, the lugs are facing each other and they will be called corresponding lugs below in this specification. The fixing lugs of a cover and of a section may be of a same or a different size depending on the point on which the perimeter cuts each of the cutting lines. A preferred option is the option in which the perimeter cuts the cutting lines on their middle point and, therefore, the fixing lugs originated both in the cover and in the section have the same size at least regarding length.

The metal sheet can be cut by means of any known cutting method such as die cutting, laser cutting, plasma cutting, oxycutting, abrasive water jet cutting, sheet punching, shearing or sawing. Obviously, any combination of the same can be utilised, die or laser cutting being the preferred options.

Subsequently, the fixing lugs need to be flattened. The fixing lugs of the sheet section (if any) can be flattened first and the fixing lugs of the cover (if any) can be flattened subsequently. The order followed to flatten is irrelevant and the fixing lugs located in the cover can be flattened first and the fixing lugs located in the section can be flattened in the second place. The flattening can be also carried out alternately in such a manner that one of the fixing lugs located in the cover is flattened first and one of the fixing lugs located in the section is then flattened and, after this, one located in the cover is flattened and so on.

'Flattening' is understood to be the fact that the fixing lugs are brought back to the existing starting plane of the stamping surface before said stamping surface was stamped.

As it has previously been stated, depending on the point on which the perimeter cuts the cutting lines, there will be lugs in the cover, or in the section or in the cover and in the section at the same time. In the flattening operation, it is taken advantage of the fact that, due to the stamping process, the length of the fixing lugs is bigger than the initial length of the sheet and that additional length allows a connecting surface to be generated, which is in charge of keeping the cover fixed on the sheet section.

Considering that at least four stamping surfaces have initially been defined, at least four fixing lugs will originate on the cut of the perimeter of the opening, which will give rise to at least four connecting surfaces along the entire perimeter of the opening.

The connecting surfaces are generated in different positions depending on the fixing lugs. If the fixing lug has been generated entirely in the cover, the connecting surface will originate in the flattening process of the same due to the additional stretched length on the metal sheet section. If the fixing lug has been generated entirely in the metal sheet section, the connecting surface will originate in the flattening process of the same due to the additional stretched length on the cover.

If the fixing lugs have correspondingly originated both in the cover and in the metal sheet section, the connecting surface will originate during the flattening process in the own fixing lug. If the fixing lug located in the cover is flattened in the first place and, subsequently, the fixing lug located in the section is flattened, the fixing lug located in the section will be the one flattened on the fixing lug located in the cover and the connecting surface will be generated from a section's fixing lug on a cover's fixing lug. If, on the contrary, the fixing lug located in the section is flattened in the first place and, subsequently, the fixing lug located in the cover is flattened, the fixing lug located in the cover will be the one flattened on the fixing lug located in the section and the connecting surface will be generated from a cover's fixing lug on a section's fixing lug.

In a preferred embodiment, all the fixing lugs located in the cover will be flattened first and, subsequently, all the fixing lugs located in the section. It is also a preferred embodiment that all the fixing lugs located in the section are flattened first and, subsequently, all the fixing lugs located in the cover.

The connecting surface is generated as a consequence of the stamping process to which the sheet is subjected in the stamping surface. Thus, as an example, and if the cutting lines are parallel to each other and perpendicular to the perimeter and their length amounts to 100 mm, a sheet stretching occurs in that area after the stamping process of the stamping surface, which will measure e.g., 120 mm. In this case, the additional 20 mm caused by the sheet stretching will be then used to create a 20 mm long connecting surface. If the stretched extension amounted up to 130 mm, the subsequent connecting surface would be 30 mm long when the fixing lugs are flattened up to the original plane of the stamping surface. If the stretched extension amounted up to 110 mm, the subsequent connecting surface would be 10 mm long when the fixing lugs are flattened up to the original plane of the stamping surface. The preferred sheet stretching range ranges from 10% to 40% of the initial length, more preferably, from 15% to 30% and, more preferably, from 20% to 25%.

Making a cover in accordance with this manufacturing and fixing method has the advantage that all the steps can be performed in just one production line and in consecutive steps. This facilitates the production of the cover on the sheet section.

Furthermore, the cover on the section remains fixed and fitted into the opening in this way. Therefore, it is structurally resistant. In addition, if access through the opening does not need to be used, the cover will stay fixed on the section permanently and without any additional means having been required.

The fact of obtaining a structurally resistant cover is very advantageous if this sheet section is used in a housing of a laundry care appliance to avoid possible damages to the laundry care appliance during its manipulation from the factory where said machine is manufactured up to the final user's dwelling. During these transfers of the laundry care appliance, it may fall and be damaged. Since the cover is structurally fixed on the section, it makes the housing of said machine more resistant and the probability of damages to the laundry care appliance is much lower. A 'laundry care appliance' is understood to be a washing machine, a dryer or a washer-dryer.

If access through the opening is required, it is only needed to deform the fixing lugs to be able to remove the cover, perform the necessary tasks through the opening and subsequently arrange the cover in place again and deform the fixing lugs again bringing them back to the initial position of the plane of the stamping surface, the cover being thereby fixed to the section again.

A cover manufactured and fixed at the same time in accordance with the invention is also advantageous for other electrical household appliances such as opening windows to have access to the fan in ovens, to the magnetron in microwave ovens, to the heat pump system in fridges, dryers with heat pumps or air conditioning equipment, inductors or resistive elements in induction stoves or glass-ceramic cooktops, etc.

This type of covers can be also used on sheet sections to access fans of deskside computers, to access pieces inside a car, etc.

In a particular embodiment, the manufacturing method according to the invention further comprises the step of
h. Generating an orifice into an area adjacent to the connecting surface in such a manner that access through said orifice is allowed for a tool.

This embodiment has the advantage that the removal of the cover from the sheet section is facilitated. If the cover is located in a visible and aesthetic sheet section, it is advantageous to have an orifice allowing access to a tool to deform the fixing lugs and be able to remove the cover from the metal sheet section without taking the risk to damage the appearance of the cover, the sheet section or both of them.

The orifice can be a through-hole of any geometry in an area adjacent to the connecting surface through which access with a tool is allowed and the fixing lugs can be deformed with e.g., a screwdriver, for example without taking the risk to damage or scratch the aesthetic and visible surface both of the section and the cover.

The orifice can be made by means of die cutting, cutting and bending of the remaining sheet, laser cutting, plasma cutting, oxycutting, abrasive water jet cutting, sheet punching, shearing or sawing, or by means of any combination of said processes. The cutting and subsequent bending of the remaining sheet is a preferred process for the generation of this orifice.

A suitable tool is understood to be any kind of screwdriver or long and thin rod allowing to lever on the fixing lugs to deform them. A trowel would be a suitable tool for the intended use too.

Subsequently, when the cover has to be mounted on the section again, the fixing lugs need to be positioned again on the original plane defined by the stamping surface. To this end, pressure can be exerted by hand or with any type of tool suitable to establish a pressure on the fixing lugs and bring them back to their position on the plane of the stamping surface, thereby fixing the cover. Sledgehammers or hammers with some kind of coating to prevent them from damaging or scratching the surface during its assembly can be utilised as well.

Furthermore, the invention relates to a metal sheet section comprising at least a cover manufactured and fixed in accordance with the method comprising the steps previously described in this specification.

This type of cover has the advantage that it is manufactured and fixed during the own manufacturing process without any additional fixing means being required and while a mechanically and structurally resistant cover is generated.

It also has the advantage that the generation of scrap metal is reduced. Since the own sheet cut-out is used as a cover on the section, the generation of scrap metal is avoided and the sheet section is used at 100%.

When an access opening is made into a sheet section, said section of the cover is weakened. Said access opening is usually closed by means of a cover not allowing access into the same and, since it is an additional piece with a different size with respect to the opening, the sheet section is weakened. In this manner, a fitted cover is achieved, which forms part of the section and helps it be resistant. On the other hand, it has the advantage that no additional fixing elements are needed since the fixing means are obtained from the own section and/or from the own sheet during the manufacture of the same.

As it has already been described, this is particularly advantageous in the case of openings that will not always be used. This is interesting, for example, in the case of sheet sections forming part of housings of electrical household appliances as an example. In the case of electrical household appliances, access openings into the same or into certain components are provided to allow them to be repaired if any maintenance or repair tasks need to be performed. If no maintenance or repair tasks need to be carried out, this cover will remain fixed on the section in such a manner that the mechanical resistance of the sheet section is not affected.

In a particular embodiment of the cover on the sheet section, the first cutting line and the second cutting line are parallel to each other.

This embodiment has the advantage that it makes the manufacturing and fixing method easier. In this manner, the stamping surface has a substantially rectangular section. This allows the stamping process to be controlled more easily to cause the stretching in the area of the stamping surface, which will then generate the fixing lugs.

Furthermore, if the cutting lines have the same length and are completely parallel to each other, the stamping surface will be rectangular, which makes the stamping process of said stamping surface and, therefore, the manufacturing method of the cover in the metal sheet section even easier.

In another particular embodiment, the cutting lines are perpendicular to the perimeter of the opening.

This embodiment has the advantage that it makes the connecting surface have a section of at least three sides of a rectangle. This allows the manufacturing and fixing method of the cover to be controlled in an easier manner. In addition, a substantially rectangular fixing section fixes the cover on the metal sheet section optimally.

The combination of cutting lines parallel to each other and perpendicular to the perimeter of the opening is particularly advantageous. In this manner, the stamping surface is rectangular and the sheet length stretched during the stamping process can be very easily controlled, so it is possible to know accurately how much section will remain available for the connecting surface, which is in charge of keeping the cover fixed to the metal sheet section.

In this way and taking the distance between the cutting lines and the length of the sheet stretched during the stamping process into account, it is very easy to know how much surface will be available for the connecting surface. In addition, in this manner, the entire surface available for the connecting surface is optimally used. If the distance between the cutting lines amounts for example to 20 mm and the distance stretched during the stamping process amounts to 20 mm more, this will result in a connecting surface with an area of 400 square millimetres in each of the fixing lugs. Considering that there are at least four fixing lugs, this embodiment guarantees at least a 1600 square millimetres connecting surface around the perimeter of the opening to fix the cover in the metal sheet section.

In another particular embodiment, the at least four fixing lugs are comprised in the section.

This situation arises when the perimeter cuts the cutting lines on one of the imaginary lines connecting the second end of the first cutting line with the second end of the second cutting line.

This embodiment is particularly advantageous if the cover is very small with respect to the section. If the section has an area much bigger than the cover, it is better to have the fixing lugs, which is the area undergoing stretching by stamping, in the bigger part, the section in this case. In this manner, the cover remains structurally intact. A cover is considered to be small relative to a section when a surface of a cover is at least five times smaller than the surface of the section, more preferably if it is at least ten times smaller and, even more preferably, if it is at least twenty times smaller.

This embodiment has in addition the advantage that, if the cover has a simple geometry such as circular, rectangular or quadrangular, the mounting and removal of the same on the section is particularly easy. Due to its lack of fixing lugs, it is much easier to be mounted and removed.

This embodiment also has the advantage that, if the surface of the cover is an aesthetic surface and the surface of the section is not, it is better for the fixing lugs to be comprised in the non- aesthetic part, so that they do not affect the aesthetic part in case they get scratched or damaged. Furthermore, it also has the advantage that, if the cover gets broken or damaged somehow, it is much easier to be replaced. In this embodiment, the cover does not need to be replaced for one comprising fixing lugs. Therefore, the spare parts are much easier to be manufactured.

In this particular embodiment, the connecting surfaces will be comprised in the cover as a consequence of the clamping the fixing lugs comprised in the section will exert on the surface of the cover.

In another particular embodiment, the at least four fixing lugs are comprised in the cover.

This situation arises when the perimeter cuts the cutting lines on one of the imaginary lines connecting the first end of the first cutting line with the first end of the second cutting line.

This embodiment is particularly advantageous if the section is small with respect to the cover. If the surface of the section has an area smaller than the surface of the cover, it is better to have the fixing lugs, which is the area undergoing stretching by stamping, in the bigger part, the cover in this case. In this manner, the section remains structurally intact. A section is considered to be small relative to a cover when a surface of a section is smaller than the surface of the cover, more preferably if it is at least five times smaller and, even more preferably, if it is at least ten times smaller.

In this particular embodiment, the connecting surfaces will be comprised in the section as a consequence of the clamping the fixing lugs comprised in the cover will exert on the surface of the section.

In another particular embodiment, the at least four fixing lugs are comprised in the section and facing the at least four fixing lugs correspondingly comprised in the cover.

In this embodiment, the perimeter of the opening cuts the cutting lines on any point differing from any of the ends of the two cutting lines. In this case, fixing lugs are formed both in the section and in the cover matching each other or facing each other. This embodiment is particularly advantageous since it is one the embodiments in which the set section-cover shows the highest structural resistance. This is particularly advantageous if the use given to said set section-cover needs to be highly mechanically resistant against impacts, for example, as it may be the case of laundry care appliances or during the own operation of a laundry care appliance due to the high number of revolutions (up to 1600 rpm) that can be reached during the spinning phases of washing programmes.

In this particular embodiment, the connecting surfaces will be comprised at least partially in the fixing lugs flattened in the first step of the process as a consequence of the clamping the fixing lugs flattened in the second step of the process will exert on the fixing lugs flattened in the first step of the process.

In another particular embodiment, the area of each fixing lug of the section is the same as the area of its corresponding fixing lug of the cover.

In this embodiment, the perimeter of the opening cuts the cutting lines on their middle point in such a manner that the surface of the fixing lugs comprised in the section will have the same length as the fixing lugs comprised in the cover. This embodiment is particularly advantageous since it is the embodiment in which the set section-cover shows the highest structural resistance. This is particularly advantageous if the use given to said set section-cover needs to be highly mechanically resistant against impacts, for example, as it may be the case of laundry care appliances or during the own operation of a laundry care appliance due to the high number of revolutions (up to 1600 rpm) that can be reached during the spinning phases of washing programmes.

In this particular embodiment, the connecting surfaces will be comprised at least partially in the fixing lugs as a consequence of the clamping the fixing lugs flattened in the second step of the process will exert on the fixing lugs flattened in the first step of the process. In this particular case, the connecting surface will most likely be comprised entirely in the fixing lug flattened in the first step of the process as a consequence of the clamping to which it will be subjected during the flattening of the corresponding fixing lug flattened in the second step of the process.

In another particular embodiment, the stamped patterns on the stamping surfaces alternate in opposite senses of the perpendicular direction defined by them and are also distributed along the entire perimeter of the opening.

This embodiment is particularly advantageous to prevent the cover from loosening accidentally due to a strong strike or impact. To improve the fixation of the cover, the best thing is to have as many stamping surfaces as possible giving rise to a higher number of fixing lugs, which will result in a higher number of connecting surfaces, as well as to alternate or interpose the stamping senses of the stamping surfaces with respect to the direction perpendicular to the plane defined by the stamping surface. Thus, for example if the plane defined by the stamping surface is the same as the plane containing the section and the cover, the direction perpendicular to the plane could be then defined as a direction having a sense out of the section opposite to the sense into the own sheet section. In this case, it is particularly advantageous if the stamping surfaces are stamped outwards and inwards in an interposed o alternating manner along the entire perimeter. This is the most advantageous configuration for the cover to remain fixed on the section in case of a strong accidental impact both in the sense out of the cover and in the sense into the cover.

In another particular embodiment, the perimeter of the opening has a polygonal geometry having at least four sides, wherein at least four of these sides are parallel to each other two by two and wherein each of these at least four sides comprise at least a connecting surface.

This embodiment is particularly advantageous since, if the cover gets damaged and needs to be replaced, this geometry allows a new spare cover to be made very easily. Furthermore, in the particular case that the fixing lugs are comprised in the section, this makes an even easier making of a spare cover possible.

On the other hand, a substantially rectangular geometry shows a very good compromise between a big opening surface and an easy geometry allowing spare covers to be prepared if required.

In another embodiment, each of the at least four sides of the perimeter of the opening, which are parallel to each other two by two, comprises at least three connecting surfaces.

This embodiment has two major advantages since the number of connecting surfaces between the section and the cover increases. This improves the fixation of the cover to the section and, in addition, in multiple areas distributed along the entire perimeter. Both factors, the increase of the number of connecting surfaces and their distribution along the entire perimeter, improve the fixation of the cover in the section.

It is also particularly advantageous to combine these two parameters with the fact that the stamped patterns of the stamping surfaces have been made in opposite senses and correlatively along the entire perimeter. This is a preferred configuration according to the invention, i.e., a configuration in which the more connecting surfaces there are, the better the fixation will be, equally distributed along the entire perimeter, a substantially regular perimeter and on which the stamped patterns of the stamping surfaces have been made in opposite senses and correlatively along the entire perimeter. This is the configuration having the best features regarding the fixation of the cover and the structural resistance of the set section-cover.

In another particular embodiment, it comprises an orifice adjacent to each of the connecting surfaces.

This embodiment has the advantage that the removal of the cover from the sheet section is facilitated. If the cover is located in a visible an aesthetic sheet section, it is advantageous to have an orifice allowing access to a tool to deform the fixing lugs and be able to remove the cover from the metal sheet section without taking the risk to damage the appearance of the cover, the sheet section or both of them.

The orifice can be a through-hole of any geometry in an area adjacent to the connecting surface through which access with a tool is allowed and the fixing lugs can be deformed with e.g., a screwdriver, without taking the risk to damage or scratch the surface both of the section and the cover.

The orifice can be made by means of die cutting, cutting and bending of the remaining sheet, laser cutting, plasma cutting, oxycutting, abrasive water jet cutting, sheet punching, shearing or sawing, or by means of any combination of said processes.

Furthermore, the invention relates to a housing comprising at least a section of the housing, which comprises a cover manufactured and fixed in accordance with any of the previously described embodiments or the combination of non-excluding embodiments of the same.

This is particularly advantageous for any device comprising a metal housing requiring or which may require access into the same to perform maintenance or repair tasks inside the same. This manufacturing and fixing method manufactures and fixes a cover of an opening section by means of which the corresponding maintenance or repair tasks can be performed through said opening.

This type of housings can be particularly advantageous in the case of laundry care appliances since, in this manner, their housing is not structurally weakened as well as for other electrical household appliances such as covers to have access to the fan in ovens, to the magnetron in microwave ovens, to the heat pump system in fridges, dryers with heat pumps or air conditioning equipment, inductors or resistive elements in induction stoves or glass-ceramic cooktops, etc.

This type of covers can be also used on sheet sections to access fans of deskside computers, to access pieces inside a car, electrical panels, etc.

In addition, the invention relates to an electrical household appliance comprising a housing, which comprises a section comprising a cover manufactured and fixed in accordance with any of the previously described embodiments or the combination of non-excluding embodiments of the same.

A 'housing' is considered to be any piece of furniture or part of a piece of furniture containing an electrical household appliance. Therefore, it should be understood that the term 'housing' includes any front, side, rear, top or bottom wall containing an electrical household appliance at least partially.

Furthermore, a section of a housing is considered to be as well the walls surrounding inner cavities for the usage of electrical household appliances such as the walls enclosing the cavity of an oven, or of a microwave oven, or of a dishwasher, or of an air conditioning equipment, a fridge, a dryer, a washing machine, a washer-dryer, etc.

Aspects and embodiments of the invention are subsequently described based on schematic drawings, in which
figure 1 is a perspective view of a perimeter of an opening defined on a metal sheet section;
figure 2 is a perspective view of the same sheet section comprising the perimeter of the opening and the cutting lines;
figure 3 is a perspective view of the same sheet section on which the stamping surfaces have been stamped;
figure 4 is a detailed view of a stamping surface stamped towards the top of the section;
figure 5 is a cut from figure 4;
figure 6 is a perspective view of the same sheet section in which the perimeter of the opening has been cut;
figure 7 is a detailed view of a stamping surface from figure 6;
figure 8 is a perspective view of the same sheet section in which the fixing lugs of the section have been flattened;
figure 9 is a detailed view of a stamping surface from figure 8;
figure 10 is a cut from figure 9;
figure 11 is a perspective view of the same sheet section in which the fixing lugs of the cover have subsequently been flattened, the connecting surface being thereby defined;
figure 12 is a detailed view of a connecting surface from figure 11;
figure 13 is a cut from figure 12;
figure 14 is a front view of a metal sheet section comprising a cover with fixing lugs both in the section and in the cover;
figure 15 is a front view of a metal sheet section comprising a rectangular cover with fixing lugs only in the section;
figure 16 is a front view of a metal sheet section comprising a rectangular cover with fixing lugs only in the cover;
figure 17 is a front view of a metal sheet section comprising a circular cover with fixing lugs only in the section;
figure 18 is a front view of a metal sheet section comprising a circular cover with fixing lugs only in the cover;
figure 19 is a perspective view of a housing of an electrical household appliance comprising a cover manufactured and fixed on its rear face;
figure 20 is a schematic view of a section of the cover of the section of the housing from figure 19 from outside the housing; and
figure 21 is a schematic view of a section of the cover of the section of the housing from figure 19 from inside the housing.

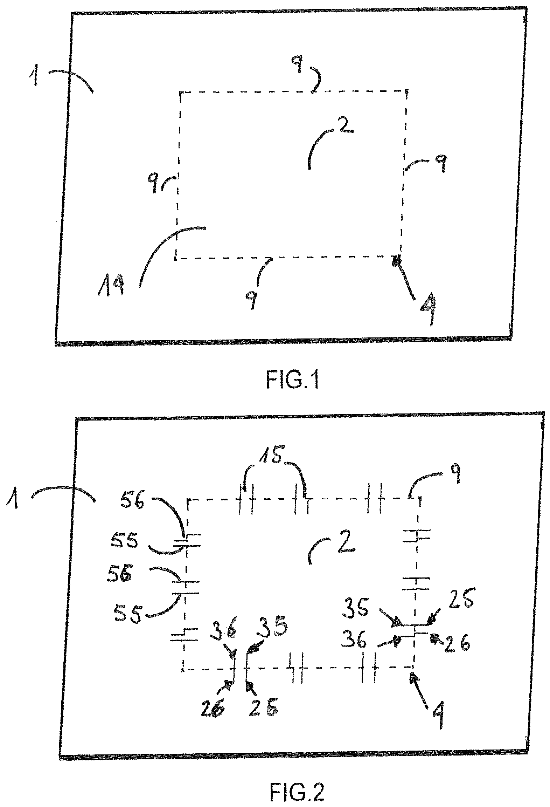

Figure 1 shows a perspective view of a metal sheet section 1 in which the perimeter 4 of an opening 14 has been defined in accordance with step a) of the manufacturing and fixing method of the cover 2. In figure 1, the perimeter 4 of the opening 14 has a rectangular geometry. Therefore, the geometry of the cover 2 will be rectangular too, although it could have any type of geometry depending on the required section for the opening 14. The preferred geometry of the perimeter 4 of the opening 14 has at least four sides 9. Two of these sides 9 are parallel to each other and perpendicular to at least other two sides 9, which are parallel to each other too.

The perimeter 4 of the opening 14 shown in figure 1 acts as a reference to carry out the rest of the steps of the manufacturing and fixing method of the cover 2 shown in the following figures.

Figure 2 shows a perspective view of the same metal sheet section 1 from figure 1 comprising the perimeter 4 of the opening 14 and the first cutting lines 55 along with the second cutting lines 56 distributed along the entire perimeter 4 of the opening 14. Figure 2 shows an example of steps b) and c) of the manufacturing and fixing method of the cover 2.

Figure 2 represents three pairs of first cutting line 55 and second cutting line 56 on each of the sides 9 of the perimeter 4 of the opening 14. This is a preferred embodiment, although it is enough with a first cutting line 55 and a second cutting line 56 on each of the sides 9 of the perimeter 4 of the opening 14.

Figure 2 represents straight first cutting lines 55 along with second cutting lines 56 that are straight too and, alternately, first cutting lines 55, which are straight too, are represented along with second cutting lines 56, which are stepped in this case. This type of stepped second cutting line 56 allows an orifice 8 to be easily generated in subsequent steps as it will be described in subsequent figures. Preferably, the stepping of the second cutting line 56 is made on the perimeter 4.

The stamping surface 15 is delimited by the first cutting line 55, the second cutting line 56 along with the imaginary line connecting the first end 25 of the first cutting line 55 with the first end 26 of the second cutting line 56 along with the imaginary line connecting the second end 35 of the first cutting line 55 with the second end 36 of the second cutting line 56. These imaginary lines connect the first ends 25, 26 and the second ends 35, 36 without intersecting.

In the case represented in figure 2, the first cutting line 55 and the second cutting line 56 are parallel to each other and perpendicular to the perimeter 4 of the opening 14. Furthermore, the ends 25, 35 of the first cutting line 55 are at the same distance to the line of the perimeter 4 of the opening 14 and this distance is the same at which each of both ends 26, 36 of the second cutting line 56 are located. Therefore, a rectangular stamping surface 15 is defined in this case. This is a preferred embodiment, although the first and second cutting line 55, 56 do not need to be parallel to each other or perpendicular to the perimeter 4 of the opening 14 and their ends 25, 26, 35, 36 do not need to be at the same distance to said perimeter 4 of the opening 14 either, so the stamping surface 15 can have different geometries.

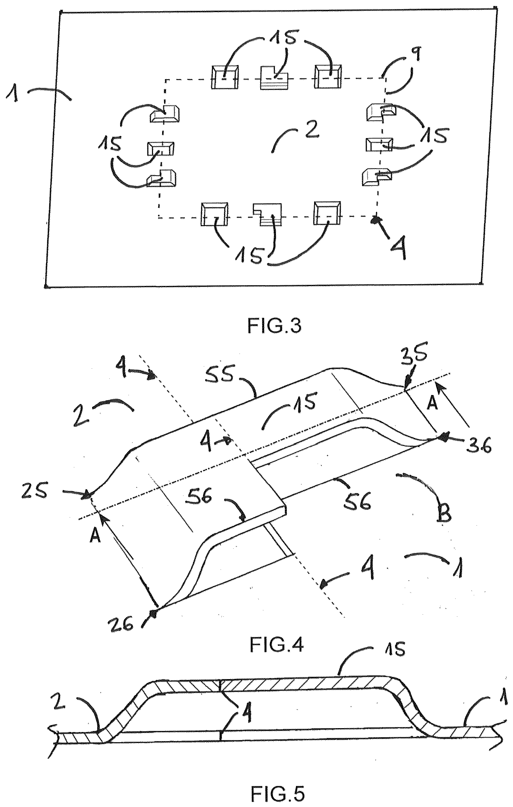

Figure 3 is a perspective view of the same metal sheet section 1 from figure 2 on which the stamping surfaces 15 have been stamped. Figure 3 shows an exemplary step d) of the manufacturing and fixing method of the cover 2.

Figure 3 shows the stamped patterns of the twelve (in the case from figure 3) stamping surfaces 15 in senses opposite to each other and in an alternating manner in such a way that each of the stamping surfaces 15 stamped in a sense is followed by a stamping surface 15 stamped in an opposite sense both in a clockwise sense of the perimeter 4 of the opening 14 and in an anti-clockwise sense of the same. In this manner, a correct fixation of the cover 2 is guaranteed. In this case, each of the stamping surfaces 15 stamped in a direction perpendicular to the stamping surface 15 and in the sense towards the top of the section 1 is surrounded both in a clockwise and anti-clockwise sense of the perimeter 4 of the opening 14 by a stamping surface 4 stamped in a direction perpendicular to the stamping surface 15 but in the sense towards the bottom of the metal sheet section 1.

Figure 3 represents twelve stamping surfaces 15, although the minimum number of said stamping surfaces 15 always amounts to four, provided that the stamping senses of said stamping surfaces 15 alternate and, next to each of the stamping surfaces 15 both in a clockwise and anti-clockwise sense, there is a stamping surface 15 stamped in an opposite sense, and said stamping surfaces 15 are distributed along the entire perimeter 4.

Figure 3 shows two types of a stamping surface 15. On the entirety of one of these types, a rectangular stamping surface corresponding to the surface comprised between the first cutting line 55 and the second cutting line 56 is stamped when both of them are straight and parallel to each other. In addition, another type of a stamping surface 15 is shown, which corresponds to the surface comprised between a first straight cutting line 55 and a second stepped cutting line 56. In this case, the stamping surface 15 has the geometry of a six-sided polygon. This will allow an orifice 8 to be generated easily.

In the example shown in figure 3, the stamping surfaces 15 comprised between straight cutting lines 55, 56 are stamped in the sense towards the bottom of the section 1, while the stamping surfaces 15 comprised between a first straight cutting line 55 and a second stepped cutting line 56 are stamped in the opposite sense, i.e., towards the top of the section 1.

Figure 4 shows a detailed example of a stamping surface 15 from figure 3. Figure 4 shows a stamping surface 15 that has been stamped in the sense towards the top of the metal sheet section 1. The first cutting line 55, which is a straight line, and the second cutting line 56, which is stepped on the perimeter 4, a surface marked as B, which will be later used to make the orifice 8, can be seen.

Figure 4 also shows the imaginary line connecting the first ends 25, 26 of the first and second cutting lines 55, 56 as well as the imaginary line connecting the second ends 35, 36 of the first and second cutting lines 55, 56, which help delimit the stamping surface 15. Figure 4 also shows the perimeter 4 in a dashed line.

Figure 5 shows the cut AA from figure 4. Figure 5 shows the stamping surface 15 on a plane over the section 1 since it shows in a detailed manner one of the stamping surfaces 15 that have been stamped in the sense towards the top of the section 1. The higher the stamping height is in this case, the bigger the connecting surface 13 will be then. The perimeter 4 coinciding in this example with the stepping of the second cutting line 56 is also shown.

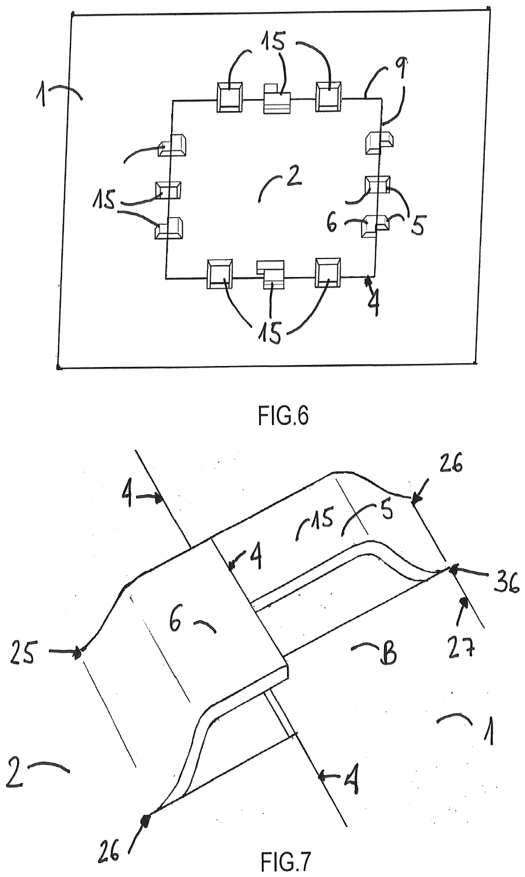

Figure 6 shows a perspective view of the same metal sheet section 1 shown in figure 3, in which, in addition, the perimeter 4 of the opening 14 has been cut. Figure 6 is therefore an exemplary step e) of the manufacturing and fixing method of the cover 2.

As a consequence of cutting the perimeter 4 of the opening 14, the fixing lugs 5, 6 are generated both in section 1 and in the cover 2. When the perimeter 4 of the opening 14 cuts the cutting lines 55, 56 on their middle point in the represented case, and since these are parallel to each other and also perpendicular to the perimeter 4 of the opening 14, fixing lugs 5, 6 corresponding to each other are generated both in the section 1 and in the cover 2. These fixing lugs 5, 6 are rectangular. The fixing lugs 5, 6 have the same size in the case of the second cutting line 56 but do not have the same size when the second cutting line 56 is stepped.

Figure 7 is a detailed view of a stamping surface 15 from figure 6. Figure 7 shows a detailed view of the same stamping surface 15 shown in figure 4 having the difference that, in the example shown in figure 7, the line of the perimeter 4 has already been cut and, for this reason, is shown with a continuous line.

Figure 7 also shows the imaginary line connecting the first ends 25, 26 of the cutting lines 55, 56 as well as the imaginary line connecting the second ends 35, 36 of the cutting lines 55, 56, which help delimit the stamping surface 15.

In addition, figure 7 shows how a lateral side 27 of surface B has been cut in the section 1, which will be used to subsequently make the orifice 8. This step is not essential since the orifice 8 is not essential and can be generated by other means and this is just an example of the generation of the orifice 8.

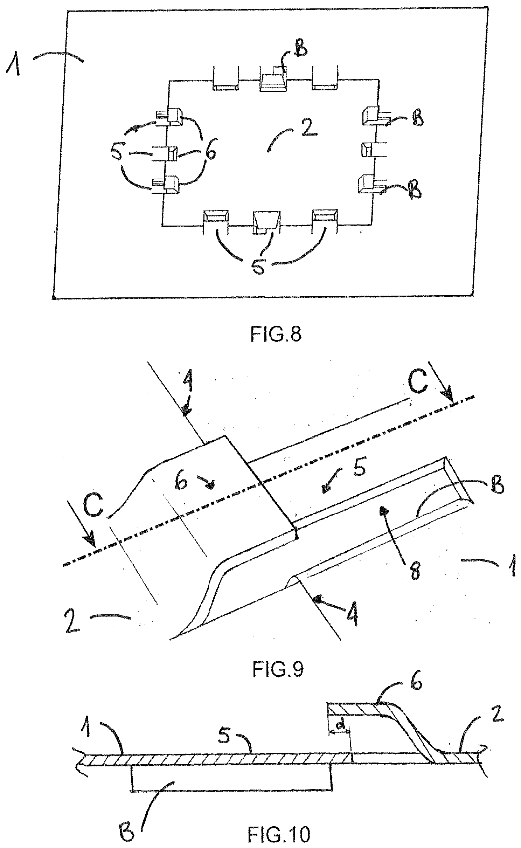

Figure 8 shows a perspective view of the same metal sheet section 1 in which the fixing lugs 5 of the section 1 have been flattened bringing them back to the starting plane of the stamping surface 15 in accordance with step f) of the manufacturing and fixing method of the cover 2.

In the case shown in figure 8, the fixing lugs 5 located in the section 1 are flattened first, although this could be done the other way round and having started by flattening the fixing lugs 6 located in the cover 2.

Figure 8 shows in addition how the sheet surface indicated as B in figure 7 has been bent towards the bottom of the section 1 in such a manner that an orifice 8 easily originates in this way.

Figure 9 is a detailed view of a stamping surface 15 from figure 8 in which the fixing lug 5 of the section 1 has already been flattened. The fixing lug 5 has been brought back to the original plane of the stamping surface 15 before being stamped by means of a flattening process.

Figure 9 shows in addition how the sheet section B has been bent towards the bottom of the section 1, a rectangular orifice 8 originating thereby in the case shown as an example.

Figure 10 shows the cut CC from figure 9. Figure 10 shows the fixing lug 5 of the section 1, which has been flattened up to the original plane of the stamping surface 15. Figure 10 also shows the distance d along which the fixing lug 5 has been stretched with respect to its original size before the stamping surface 15 has been stamped.

In addition, figure 10 shows the fixing lug 6 of the cover 2 on a plane over the section 1. Figure 10 also shows the surface B, which has been bent towards the bottom of the section 1.

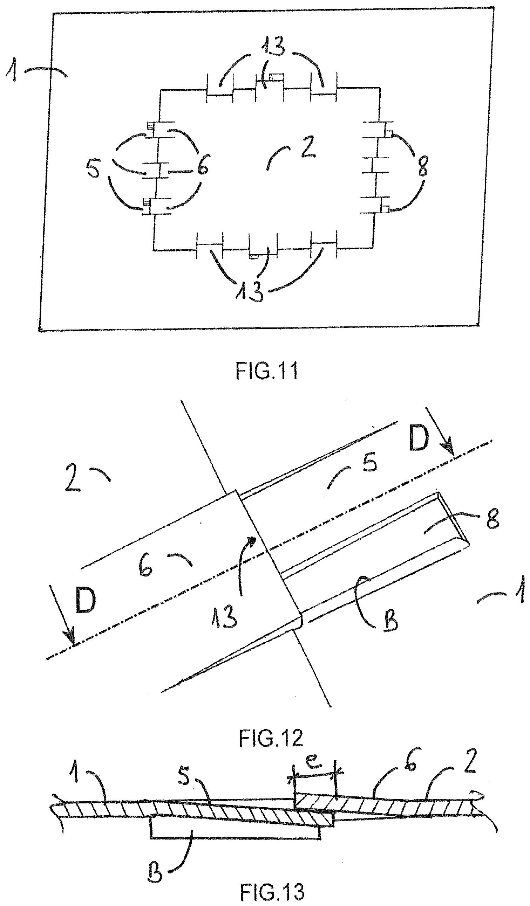

Figure 11 shows a perspective view of the same metal sheet section 1 shown in figure 8 in which the fixing lugs 6 of the cover 2 have been flattened in a subsequent step, thereby bringing them back to the starting plane of the stamping surface 15 in accordance with step g) of the manufacturing and fixing method of the cover 2. Figure 11 shows how the fixing lugs 6 clamp the fixing lugs 5 in a overlapping area. A connecting surface 13 is thereby created, which maintains the cover 2 fixed in the section 1.

If the fixing lugs 6 located in the cover 2 had been flattened first, bringing them back to the position of the starting plane of the stamping surface 15, in that case the fixing lugs 5 located in the section 1 would have clamped the fixing lugs 6 in a overlapping area, a connecting surface 13 being thereby created to maintain the cover 2 fixed in the section 1.

In addition, figure 11 shows connecting surfaces 13 in which there are no orifices 8 adjacent to the same. Exemplary connecting surfaces 13 having orifices 8 adjacent to said connecting surfaces 13 are also shown.

Figure 11 also shows how there are connecting surfaces 13 generated by the clamping of the fixing lugs 5 on the fixing lugs 6 and, alternately, there are connecting surfaces 13 generated by the clamping of the fixing lugs 6 on the fixing lugs 5.

Figure 12 is a detailed view of a connecting surface 13 from figure 11 and corresponding to the evolution from figure 9, in which the fixing lug 6 of the cover 2 has been flattened. When the fixing lug 6 is flattened, the connecting surface 13 originates.

Figure 12 also shows the orifice 8 in the section 1 and adjacent to the connecting surface 13 easily allowing the fixing lug 6 to be deformed by levering if the cover 2 needs to be removed.

Figure 13 shows the cut DD from figure 12. Figure 13 shows the fixing lug 6 of the cover 2, which has been flattened up to the original plane of the stamping surface 15, thereby clamping the fixing lug 5 of the section 1 previously flattened. Figure 13 also shows the distance e of the connecting surface 13, which corresponds to the stretching of the stamping surface 15 during the stamping process.

Figure 13 also shows the surface B, which has previously been bent towards the bottom of the section 1.

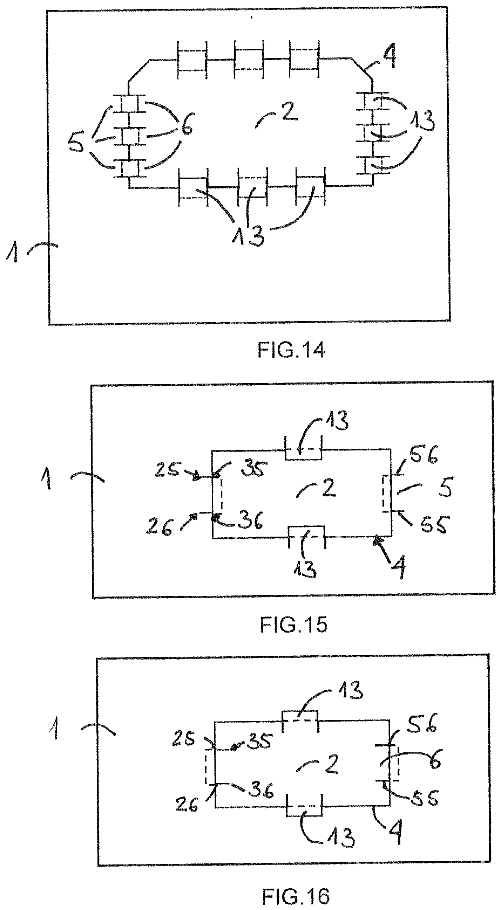

Figure 14 shows a front view of a metal sheet section 1 comprising a cover 2 with fixing lugs 5, 6 both in the section 1 and in the cover 2. The example shown in figure 14 belongs to the inventive concept shown throughout figures 1, 2, 3 6, 8 and 11 with a couple of differences.

The first difference consists in that, in figure 14, a perimeter 4 of an opening 14 with a geometry having six sides 9, instead of a rectangular perimeter, is shown. The second difference is that, in figure 14, no orifices 8 are shown in areas adjacent to any connecting surface 13. Therefore, in the case shown in figure 14, both the first cutting line 55 and the second cutting line 56 are straight, parallel to each other and perpendicular to the perimeter 4.

The perimeter 4 shown in figure 14 has a geometry with six sides 9, two of them being parallel to each other and perpendicular to other two sides 9, which are also parallel to each other. Furthermore, figure 14 shows three connecting surfaces 13 on each of these four sides 9, which are parallel to each other two by two and perpendicular to the other two sides 9. No connecting surfaces 13 are shown on the other two sides 9 of the perimeter 4, although said surfaces could exist.

In figure 14, the fixing lugs 5 placed in the section 1 have been flattened first, bringing them back to the starting plane of the stamping surface 15, and the fixing lugs 6 of the cover 2 have been flattened in a subsequent step, bringing them back to the starting plane of the stamping surface 15, and with the fixing lugs 6 clamping the fixing lugs 5 in a overlapping area, a connecting surface 13 being thereby created, which maintains the cover 2 fixed in the section 1.

If the fixing lugs 6 located in the cover 2 had been flattened first, bringing them back to the position of the starting plane of the stamping surface 15, in that case the fixing lugs 5 located in the section 1 would have clamped the fixing lugs 6 in a overlapping area, a connecting surface 13 being thereby created to maintain the cover 2 fixed in the section 1. There is no need to flatten first all the fixing lugs 5 of the section 1 and subsequently flatten all the fixing lugs 6 placed in the cover 2. This can be alternatively done by flattening first one of the fixing lugs 5 located in the section 1, subsequently flattening one of the fixing lugs 6 located in the cover 2 and so on until all the fixing lugs 5, 6 have been flattened.

Figure 15 shows a front view of a metal sheet section 1 comprising a rectangular cover 2 with fixing lugs 5 just in the section 1. This occurs when the perimeter 4 coincides with the imaginary line connecting the second end 35 of the first cutting line 55 with the second end 36 of the second cutting line 56.

In the example shown in figure 15, the cutting lines 55, 56 are perpendicular to the perimeter 4 of the opening 14 and parallel to each other.

In the case shown in figure 15, the four fixing lugs 5 originate in the section 1.

While fixing lugs 6 could originate in the cover 2, others could originate in the section 1, and fixing lugs 5 could also originate in the section 1 in front of their corresponding fixing lugs 6 located in the cover 2. Any combination of fixing lugs 5, 6 located in the cover 2 or in the section 1 or in the section 1 and in the cover 2 is possible provided that the stamping surfaces 15 are stamped alternately in opposite senses.

If the distance between the cutting lines 55, 56 was equal to the distance between the ends 25, 26, 35, and 36 of the cutting lines 55, 56 with respect to the perimeter 4 of the opening 14, the fixing lugs 5, 6 would be squared.

Figure 15 also shows the four connecting surfaces 13 corresponding to the example shown in this figure.

Figure 16 shows a front view of a metal sheet section 1 comprising a rectangular cover 2 with fixing lugs 6 only in the cover 2. This occurs when the perimeter 4 coincides with the imaginary line connecting the first end 25 of the first cutting line 55 with the first end 26 of the second cutting line 56.

In the example shown in figure 16, the cutting lines 55, 56 are perpendicular to the perimeter 4 of the opening 14 and parallel to each other.

In the case shown in figure 16, the four fixing lugs 6 originate in the cover 2.

As it has been described in the preceding figure, fixing lugs 5 could originate in the section 1, others could originate in the cover 2, and fixing lugs 5 could also originate in the section 1 in front of their corresponding fixing lugs 6 located in the cover 2. Any combination of fixing lugs 5, 6 located in the section 1 and in the cover 2 or in the cover 2 or in the section 1 is always possible.

If the distance between the cutting lines 55, 56, these being parallel to each other, was equal to the distance between the ends 25, 26, 35, and 36 of the cutting lines 55, 56 with respect to the perimeter 4 of the opening 14, the fixing lugs 5, 6 would be squared.

Figure 16 also shows the four connecting surfaces 13 corresponding to the example shown in this figure.

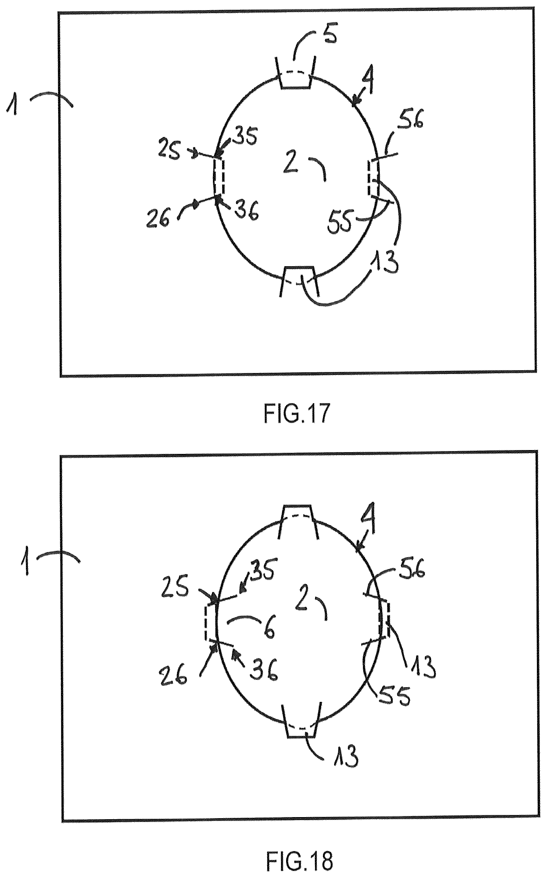

Figure 17 shows a front view of a metal sheet section 1 comprising a circular cover 2 with fixing lugs 5 only in the section 1. This occurs when the perimeter 4 coincides with the imaginary line connecting the second end 35 of the first cutting line 55 with the second end 36 of the second cutting line 56.

In the example shown in figure 17, the cutting lines 55, 56 are perpendicular to the perimeter 4 of the opening 14 and, in this case, are not parallel to each other but both converge on the centre of the circle of the perimeter 4, so trapezoidal fixing lugs 5 originate.

In the case shown in figure 17, the four fixing lugs 5 originate in the section 1.

In the case shown in figure 17, the four fixing lugs 5 originate in the section 1, although some of them could originate in the cover 2, others in the section 1, and fixing lugs 5 could also originate in the section 1 in front of their corresponding fixing lugs 6 located in the cover 2. Any combination of fixing lugs 5, 6 located in the cover 2 or in the section 1 or in the section 1 and in the cover 2 is possible provided that the stamping surfaces 15 are stamped alternately in opposite senses.

Figure 17 also shows the four connecting surfaces 13 corresponding to the example shown in this figure.

Figure 18 shows a front view of a metal sheet section 1 comprising a circular cover 2 with fixing lugs 6 only in the cover 2. This occurs when the perimeter 4 coincides with the imaginary line connecting the first end 25 of the first cutting line 55 with the first end 26 of the second cutting line 56.

In the example shown in figure 18, the cutting lines 55, 56 are perpendicular to the perimeter 4 of the opening 14 and, in this case, are not parallel to each other but both converge on points external to the centre of the circle of the perimeter 4, so trapezoidal fixing lugs 5 originate.

In the case shown in figure 18, the four fixing lugs 6 originate in the cover 2.

In the case shown in figure 18, the four fixing lugs 6 originate in the section 1, although some of them could originate in the cover 2, others in the section 1, and fixing lugs 5 could also originate in the section 1 in front of their corresponding fixing lugs 6 located in the cover 2. Any combination of fixing lugs 5, 6 located in the cover 2 or in the section 1 or in the section 1 and in the cover 2 is possible provided that the stamping surfaces 15 are stamped alternately in opposite senses.

Figure 18 also shows the four connecting surfaces 13 corresponding to the example shown in this figure.

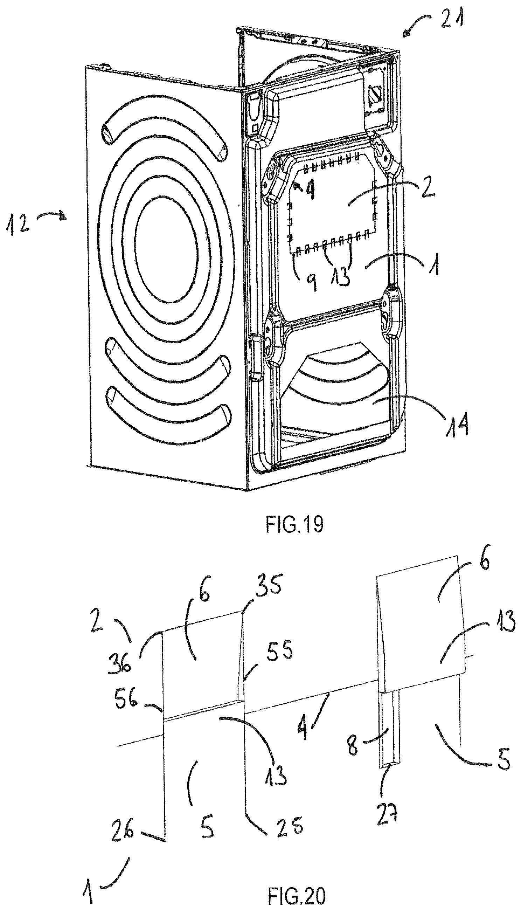

Figure 19 shows a perspective view of a housing 21 of an electrical household appliance 12 comprising a cover 2 manufactured and fixed in the section 1 of its rear face. The cover 2 shown in figure 19 maintains the same inventive concept as the cover 2 shown and described in figure 14.

The cover 2 from figure 19 comprises nine connecting surfaces 13 on the longest side 9 of the perimeter 4 of the opening 14. It further comprises seven connecting surfaces 13 on the side 9 parallel to the longest side 9 of the perimeter 4 of the opening 14 as well as three connecting surfaces 13 on each of the sides 9 parallel to each other and perpendicular to the longest sides 9 of the perimeter 4 of the opening 14. The other two sides do not comprise any connecting surface 13, but they could be added if required.

The rear part of the housing 21 shown in figure 19 shows a second opening 14, which could be also covered by a cover 2 manufactured and fixed in accordance with the proposed manufacturing method.

The housing 21 shown in figure 19 belongs to a laundry care appliance, a washing machine in this case. The cover 2 of the rear top will only need to be removed from its position in case of failure of the pulley moving the drum or of the conveyor belt connecting the pulley to the motor pinion. Since this failure is improbable and the number of cases in which it is required to access the interior of the electrical household appliance 12 (a washing machine in this case) is very reduced, a cover 2 manufactured and fixed in accordance with the method described in this specification is particularly advantageous since, on the one hand, it is mechanically resistant, which favours the mechanical behaviour of the housing and, if the unlikely case of a necessary removal happens, it can be removed and mounted again.

Figure 19 shows a cover 2 of a section 1 of a housing 21 arranged in the rear part of said housing 21. The cover 2 could be equally placed in any of its lateral faces, front section, top cover, bottom cover or in several of them at the same time.

Furthermore, a cover 2 manufactured and fixed at the same time in accordance with the invention is also advantageous for other electrical household appliances 12 such as opening windows 14 to have access to a component such as a fan in ovens, to the magnetron in microwave ovens, to the heat pump system in fridges, dryers with heat pumps or air conditioning equipment, inductors or resistive elements in induction stoves or glass-ceramic cooktops, etc.

This type of covers can be also used on sheet sections to access fans of deskside computers, to access pieces inside a car, etc.

Figure 20 shows a schematic view of a section of the cover 2 of the section 1 of the housing 21 from figure 19 from outside the own housing 21. Figure 20 shows a detail of two fixing lugs 5 of the section 1 having their corresponding fixing lug 6 in the cover 2 and which have been stamped in opposite senses within the direction perpendicular to the plane defined by the stamping surface 15. In the connection shown in figure 20, the fixing lugs 5 of the section 1 have been flattened first and the fixing lugs 6 of the cover 2 have subsequently been flattened. In this manner, the fixing lugs 5 are clamped and a connecting surface 13 is created.

It can be also seen in the right lug from figure 20 that an orifice 8 has been created allowing a tool to be used to deform the fixing lug 6 if the cover 2 needs to be removed from the section 1. The orifice 8 has been created by cutting the lateral side 27 and bending it into the sheet housing 21 of the section 1. It is particularly advantageous to arrange the orifice 8 in the section 1, in this case, next to the connecting surface 13 on a stamping surface that has been stamped out of the housing 21 to be able to deform in this case the fixing lug 6 located in the cover 2. It is thereby avoided to damage a part that is aesthetic or visible to the user during the removal process of the cover 2.

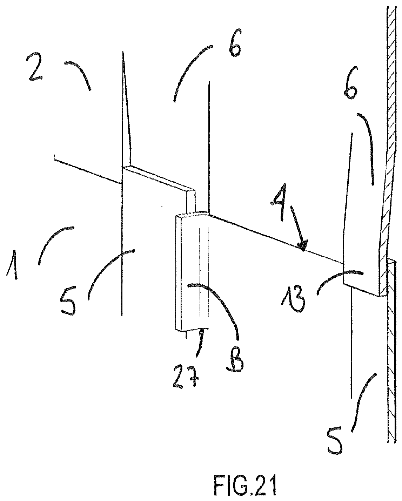

Figure 21 shows a schematic view of a section of the cover 2 of the section 1 of the housing 21 from figure 19 from inside the own housing 21. Figure 21 shows a detail of a fixing lug 5 of the section 1 having its corresponding fixing lug 6 in the cover 2 and another fixing lug 5 of the section 1 having its corresponding fixing lug 6 in the cover 2 is partially shown, wherein both of them have been stamped in opposite senses within the direction perpendicular to the plane defined by the stamping surface 15. In the connection shown in figure 21, the fixing lugs 5 of the section 1 have been flattened first and the fixing lugs 6 of the cover 2 have subsequently been flattened. In this manner, the fixing lugs 5 are clamped and a connecting surface 13 is created.

It can be also seen in the left lug from figure 21 that an orifice 8 has been created allowing a tool to be used to deform the fixing lug 6 if the cover 2 needs to be removed from the section 1. The orifice 8 has been created by cutting the lateral side 27 and bending the surface B of the section 1 into the housing 21. It is particularly advantageous to arrange the orifice 8 in the section 1, in this case, next to the connecting surface 13 on a stamping surface 15 that has been stamped out of the housing 21 to be able to deform in this case the fixing lug 6 located in the cover 2 to avoid damages to a part that is aesthetic or visible to the user during the removal process of the cover 2.

### Reference numerals

- 1: section
- 2: cover
- 4: perimeter
- 5: fixing lug
- 6: fixing lug
- 8: orifice
- 9: side
- 12: electrical household appliance
- 13: connecting surface
- 14: opening
- 15: stamping surface
- 21: housing
- 25: first end
- 26: first end
- 27: lateral side
- 35: second end
- 36: second end
- 55: first cutting line
- 56: second cutting line
- B: surface for orifice
- d: distance
- e: distance

## Claims

1. A manufacturing and fixing method of a cover (2) removable from an opening (14) of a metal sheet section (1) comprising the following steps:
a. Defining a perimeter (4) of the opening (14),
b. Cutting a first cutting line (55) comprising a first end (25) and a second end (35) and cutting a second cutting line (56) comprising a first end (26) and a second end (36) in such a manner that they cut the perimeter (4) of the opening (14), a stamping surface (15) being thereby defined between the cutting lines (55, 56),
c. Repeating step b) at least three times along the perimeter (4) of the opening (14), a total of at least four stamping surfaces (15) being thereby defined,
d. Stamping the at least four stamping surfaces (15) in a direction perpendicular to the plane defined by the stamping surface (15) in such a manner that there are at least two stamping surfaces (15) stamped in opposite senses of said direction perpendicular to the plane defined by the stamping surface (15) in an alternating manner among the stamping surfaces (15),
e. Cutting the perimeter (4) of the opening (14), at least four fixing lugs (5, 6) being thereby defined,
f. Flattening the fixing lugs (5, 6) located in the section (1), thereby bringing them back to the starting plane of the stamping surface (15),
g. Flattening the fixing lugs (5, 6) located in the cover (2), thereby bringing them back to the starting plane of the stamping surface (15) in such a manner that at least four connecting surfaces (13) are defined, or on the cover (2) or on the section (1) or on another fixing lug (5, 6) in such a manner that the cover (2) remains fixed to the section (1) without any additional fixing means

2. The manufacturing method of a cover (2) according to claim 1, further comprising the step:
h. Generating an orifice (8) into an area adjacent to the connecting surface (13) in such a manner that access through said orifice (8) is allowed for a tool.

3. A metal sheet section (1) comprising at least a cover (2) manufactured and fixed in accordance with the method according to any of claims 1 to 2.

4. The section (1) according to claim 3, **characterized in that** the cutting lines (55, 56) are parallel to each other.

5. The section (1) according to any of claims 3 to 4, **characterized in that** the cutting lines (55, 56) are perpendicular to the perimeter (4) of the opening (14).

6. The section (1) according to any of claims 3 to 5, **characterized in that** the at least four fixing lugs (5) are comprised in the section (1).

7. The section (1) according to any of claims 3 to 5, **characterized in that** the at least four fixing lugs (6) are comprised in the cover (2).

8. The section (1) according to any of claims 3 to 5, **characterized in that** the at least four fixing lugs (5) are comprised in the section (1) and facing the at least four fixing lugs (6) correspondingly comprised in the cover (2).

9. The section (1) according to claim 8, **characterized in that** the area of each fixing lug (5) of the section (1) is the same as the area of its corresponding fixing lug (6) of the cover (2).

10. The section (1) according to any of claims 3 to 9, **characterized in that** the stamped patterns on the stamping surfaces (15) alternate in opposite senses of the perpendicular direction defined by them and are also distributed along the entire perimeter (4) of the opening (14).

11. The section (1) according to any of claims 3 to 10, **characterized in that** the perimeter (4) of the opening (14) has a polygonal geometry having at least four sides (9), wherein at least four of these sides (9) are parallel to each other two by two and wherein each of these at least four sides (9) comprise at least a connecting surface (13).

12. The section (1) according to claim 11, **characterized in that** each of the at least four sides (9) of the perimeter (4) of the opening (14), which are parallel to each other two by two, comprises at least three connecting surfaces (13).

13. The section (1) according to any of claims 3 to 12, **characterized in that** it comprises an orifice (8) adjacent to each of the connecting surfaces (13).

14. A housing (21) comprising at least a section (1) of the housing (21) according to any of claims 3 to 13.

15. An electrical household appliance (12) comprising a housing (21) according to claim 14.

## Patentansprüche

1. Fertigungs- und Befestigungsverfahren für eine Abdeckung (2), die von einer Öffnung (14) in einem Blechprofil (1) abnehmbar ist, mit folgenden Schritten:
a. Definieren eines Umfangs (4) der Öffnung (14),
b. derartiges Schneiden einer ersten Schnittlinie (55), die ein erstes Ende (25) und ein zweites Ende (35) umfasst, und einer zweiten Schnittlinie (56), die ein erstes Ende (26) und ein zweites Ende (36) umfasst, dass sie den Umfang (4) der Öffnung (14) schneiden, wodurch zwischen den Schnittlinien (55, 56) eine Stanzfläche (15) definiert wird,
c. mindestens dreimaliges Wiederholen von Schritt b) entlang dem Umfang (4) der Öffnung (14), wodurch insgesamt mindestens vier Stanzflächen (15) definiert werden,
d. derartiges Stanzen der mindestens vier Stanzflächen (15) in einer senkrecht zur von der Stanzfläche (15) definierten Ebene verlaufenden Ausrichtung, dass unter den Stanzflächen (15) abwechselnd mindestens zwei Stanzflächen (15) in entgegengesetzten Richtungen der senkrecht zur von der Stanzfläche (15) definierten Ebene verlaufenden Ausrichtung gestanzt werden,
e. Schneiden des Umfangs (4) der Öffnung (14), wodurch mindestens vier Befestigungslaschen (5, 6) definiert werden,
f. Flachdrücken der Befestigungslaschen (5, 6) in dem Profil (1), wodurch sie in die Ausgangsebene der Stanzfläche (15) zurück gebracht werden,
g. derartiges Flachdrücken der Befestigungslaschen (5, 6) in der Abdeckung (2), wodurch sie in die Ausgangsebene der Stanzfläche (15) zurückgebracht werden, dass mindestens vier Verbindungsflächen (13) definiert werden, oder an der Abdeckung (2) oder an dem Profil (1) oder an einer anderen Befestigungslasche (5, 6), dass die Abdeckung (2) ohne zusätzliche Befestigungsmittel an dem Profil (1) befestigt bleibt.

2. Fertigungsverfahren für eine Abdeckung (2) nach Anspruch 1, das ferner folgenden Schritt umfasst:
h. derartiges Erzeugen einer Mündung (8) in einem an die Verbindungsfläche (13) angrenzenden Bereich, dass über die Mündung (8) für ein Werkzeug Zugang dazu besteht.

3. Blechprofil (1) mit mindestens einer Abdeckung (2), die dem Verfahren nach einem der Ansprüche 1 bis 2 entsprechend gefertigt und befestigt wurde.

4. Profil (1) nach Anspruch 3, **dadurch gekennzeichnet, dass** die Schnittlinien (55, 56) parallel zueinander verlaufen.

5. Profil (1) nach einem der Ansprüche 3 bis 4, **dadurch gekennzeichnet, dass** die Schnittlinien (55, 56) senkrecht zum Umfang (4) der Öffnung (14) verlaufen.

6. Profil (1) nach einem der Ansprüche 3 bis 5, **dadurch gekennzeichnet, dass** die mindestens vier Befestigungslaschen (5) in dem Profil (1) enthalten sind.

7. Profil (1) nach einem der Ansprüche 3 bis 5, **dadurch gekennzeichnet, dass** die mindestens vier Befestigungslaschen (6) in der Abdeckung (2) enthalten sind.

8. Profil (1) nach einem der Ansprüche 3 bis 5, **dadurch gekennzeichnet, dass** die mindestens vier Befestigungslaschen (5) in dem Profil (1) enthalten und den mindestens vier Befestigungslaschen (6) zugewandt sind, die entsprechend in der Abdeckung (2) enthalten sind.

9. Profil (1) nach Anspruch 8, **dadurch gekennzeichnet, dass** die Fläche jeder Befestigungslasche (5) des Profils (1) der Fläche ihrer entsprechenden Befestigungslasche (6) der Abdeckung (2) gleicht.

10. Profil (1) nach einem der Ansprüche 3 bis 9, **dadurch gekennzeichnet, dass** die gestanzten Muster auf den Stanzflächen (15) in entgegengesetzten Richtungen der von ihnen definierten senkrechten Ausrichtung abwechseln und auch den gesamten Umfang (4) der Öffnung (14) entlang verteilt sind.

11. Profil (1) nach einem der Ansprüche 3 bis 10, **dadurch gekennzeichnet, dass** der Umfang (4) der Öffnung (14) eine mehreckige Geometrie mit mindestens vier Seiten (9) aufweist, wobei jeweils zwei von mindestens vier dieser Seiten (9) parallel zueinander verlaufen und diese mindestens vier Seiten (9) jeweils zumindest eine Verbindungsfläche (13) umfassen.

12. Profil (1) nach Anspruch 11, **dadurch gekennzeichnet, dass** jede der mindestens vier Seiten (9) des Umfangs (4) der Öffnung (14), von denen jeweils zwei parallel zueinander verlaufen, mindestens drei Verbindungsflächen (13) umfasst.

13. Profil (1) nach einem der Ansprüche 3 bis 12, **dadurch gekennzeichnet, dass** es eine an jede der Verbindungsflächen (13) angrenzende Mündung (8) umfasst.

14. Gehäuse (21) mit mindestens einem Profil (1) nach einem der Ansprüche 3 bis 13.

15. Elektrisches Haushaltsgerät (12) mit einem Gehäuse (21) nach Anspruch 14.

## Revendications

1. Procédé de fabrication et de fixation d'un couvercle (2) amovible, depuis une ouverture (14) d'une section (1) de feuille métallique comprenant les étapes suivantes consistant à :
a. définir un périmètre (4) de l'ouverture (14),
b. couper une première ligne de découpe (55) comprenant une première extrémité (25) et une seconde extrémité (35) et couper une seconde ligne de découpe (56) comprenant une première extrémité (26) et une seconde extrémité (36) d'une manière telle qu'elles coupent le périmètre (4) de l'ouverture (14), une surface d'emboutissage (15) étant définie ainsi entre les lignes de découpe (55, 56),
c. répéter l'étape b) au moins trois fois le long du périmètre (4) de l'ouverture (14), un total d'au moins quatre surfaces d'emboutissage (15) étant ainsi défini,
d. emboutir les au moins quatre surfaces d'emboutissage (15) dans un sens perpendiculaire au plan défini par la surface d'emboutissage (15) d'une manière telle qu'il existe au moins deux surfaces d'emboutissage (15) embouties dans des sens opposés dudit sens perpendiculaire au plan défini par la surface d'emboutissage (15) d'une manière alternée parmi les surfaces d'emboutissage (15),
e. couper le périmètre (4) de l'ouverture (14), au moins quatre pattes de fixation (5, 6) étant ainsi définies,
f. aplatir les pattes de fixation (5, 6) localisées dans la section (1), les portant ainsi en retour vers le plan de départ de la surface d'emboutissage (15),
g. aplatir les pattes de fixation (5, 6) localisées dans le couvercle (2), les portant ainsi en retour vers le plan de départ de la surface d'emboutissage (15) d'une manière telle qu'au moins quatre surfaces de raccordement (13) sont définies, ou sur le couvercle (2) ou sur la section (1) ou sur une autre patte de fixation (5, 6) d'une manière telle que le couvercle (2) demeure fixé à la section (1) sans quelconque moyen de fixation additionnel.

2. Procédé de fabrication d'un couvercle (2) selon la revendication 1, comprenant en outre l'étape consistant à :
h. générer un orifice (8) dans une zone adjacente à la surface de raccordement (13) d'une manière telle qu'un accès à travers ledit orifice (8) est permis pour un outil.

3. Section (1) de feuille métallique comprenant au moins un couvercle (2) fabriqué et fixé selon le procédé selon l'une quelconque des revendications 1 à 2.

4. Section (1) selon la revendication 3, **caractérisée en ce que** les lignes de découpe (55, 56) sont parallèles l'une à l'autre.

5. Section (1) selon l'une quelconque des revendications 3 à 4, **caractérisée en ce que** les lignes de découpe (55, 56) sont perpendiculaires au périmètre (4) de l'ouverture (14).

6. Section (1) selon l'une quelconque des revendications 3 à 5, **caractérisée en ce que** les au moins quatre pattes de fixation (5) sont comprises dans la section (1).

7. Section (1) selon l'une quelconque des revendications 3 à 5, **caractérisée en ce que** les au moins quatre pattes de fixation (6) sont comprises dans le couvercle (2).

8. Section (1) selon l'une quelconque des revendications 3 à 5, **caractérisée en ce que** les au moins quatre pattes de fixation (5) sont comprises dans la section (1) et font face à les au moins quatre pattes de fixation (6) comprises de manière correspondante dans le couvercle (2).

9. Section (1) selon la revendication 8, **caractérisée en ce que** la zone de chaque patte de fixation (5) de la section (1) est identique à la zone de sa patte de fixation (6) correspondante du couvercle (2).

10. Section (1) selon l'une quelconque des revendications 3 à 9, **caractérisée en ce que** les motifs emboutis des surfaces d'emboutissage (15) alternent dans des sens opposés du sens perpendiculaire défini par eux et sont également répartis le long du périmètre (4) entier de l'ouverture (14).

11. Section (1) selon l'une quelconque des revendications 3 à 10, **caractérisée en ce que** le périmètre (4) de l'ouverture (14) présente une géométrie polygonale ayant au moins quatre côtés (9), dans laquelle au moins quatre de ces côtés (9) sont parallèles l'un à l'autre deux par deux et dans laquelle chacun de ces au moins quatre côtés (9) comprend au moins une surface de raccordement (13).

12. Section (1) selon la revendication 11, **caractérisée en ce que** chacun des au moins quatre côtés (9) du périmètre (4) de l'ouverture (14), qui sont parallèles l'un à l'autre deux par deux, comprend au moins trois surfaces de raccordement (13).

13. Section (1) selon l'une quelconque des revendications 3 à 12, **caractérisée en ce qu'**elle comprend un orifice (8) adjacent à chacune des surfaces de raccordement (13).

14. Logement (21) comprenant au moins une section (1) du logement (21) selon l'une quelconque des revendications 3 à 13.

15. Appareil électroménager (12) comprenant un logement (21) selon la revendication 14.
